# EUROPÄISCHE PATENTANMELDUNG

(11) **EP 1 427 013 A2**
(43) Veröffentlichungstag der Anmeldung: **09.06.2004**
(21) Anmeldenummer: 04005427.2
(22) Anmeldetag: 20.09.2000
(51) Int. Cl.: H01L 23/367, H05K 1/02

(54) **Steuergerät, insbesondere für die Kraftfahrzeugtechnik**

(30) Priorität: 22.09.1999 DE 19945428
(62) Teilanmeldung aus: 00963990.7
(71) Anmelder: SIEMENS AKTIENGESELLSCHAFT, 80333 München (DE)
(72) Erfinder: Haupt, Detlef, 93128 Steinsberg (DE); Maurer, Thomas, 93059 Regensburg (DE)

(57) **Zusammenfassung**

Das Steuergerät (20) ist mit einem elektrischen Bauelement (2) bestückt, in dem Wärme erzeugt wird. Diese wird über ein längliches Metallteil (21) abgeführt wird, dessen eine Stirnfläche (22) mit dem Bauelement (2) verlötet ist. Die dem Bauelement (2) zugewandte Stirnfläche (22) weist eine ihre Oberfläche vergrößernde Gestalt auf. Sie ist nach außen gewölbt ausgebildet und kann mit einer Riffelung versehen sein.

## Beschreibung

Die Erfindung betrifft ein Steuergerät nach dem Oberbegriff von Anspruch 1. Solche Steuergeräte sind insbesondere für den Einsatz in Kraftfahrzeugen vorgesehen. Sie weisen in der Regel mehrere elektrische und elektronische Bauelemente auf, in denen beim Betrieb des Steuergeräts Verlustwärme erzeugt wird. Diese Wärme muss wirksam abgeführt werden, wenn die hoch belasteten Bauelemente nicht zerstört werden sollen.

Bei einem bekannten elektrischen Gerät ist ein thermisch hochbelastetes Bauelement durch eine Wärmeleitbrücke in Form eines länglichen Metallkörpers oder Kupferbolzens mit einer Kühlplatte verbunden (DE 195 32 992 A1). Der Kupferbolzen ist verzinnt und wird mit dem Bauelement verlötet.

Der Kupferbolzen weist auf seiner dem Bauelement zugewandten Seite eine glatte Oberfläche auf. Unter besonderen Umständen kann die mit dem Bauelement verbundene Oberfläche des Kupferbolzens nicht ausreichen, um genügend Wärme abzuführen.

Der Erfindung liegt das technische Problem zugrunde, ein Steuergerät zu schaffen, in dem die Wärmeabfuhr auch bei hoher Belastung des oder der Bauelemente ausreichend ist, d. h. in dem bei gegebener Größe des wärmeabführenden Metallteils die Wärmeabfuhr erhöht ist.

Das genannte technische Problem wird durch ein Steuergerät nach Anspruch 1 gelöst. Dabei weist die dem Bauelement zugewandte Stirnfläche eine ihre Oberfläche vergrößernde Gestalt auf. Sie ist nach außen mit einer Riffelung versehen. Das als Wärmebrücke dienende längliche Metallteil kann als Niet, insbesondere als Kupferniet ausgebildet sein.

Die Vorteile der Erfindung liegen insbesondere darin, dass der prozentuale Anteil der Lötfläche an dem wärmeabführenden Gesamtvolumen erhöht ist. Insbesondere wird eine Verbesserung und Optimierung des Lötprozesses erzielt. Durch die Gestalt der verlöteten Stirnfläche wird eine Luftblasenbildung in dem Lötzinn erheblich verringert. Dies erhöht wiederum die Wärmeabfuhr.

Ausführungsbeispiele der Erfindung werden im folgenden anhand der Zeichnung erläutert. Es zeigen:
- Figur 1: ein Steuergerät gemäß der Erfindung in schematischer Darstellung und
- Figur 2: ein Steuergerät gemäß dem Stand der Technik.

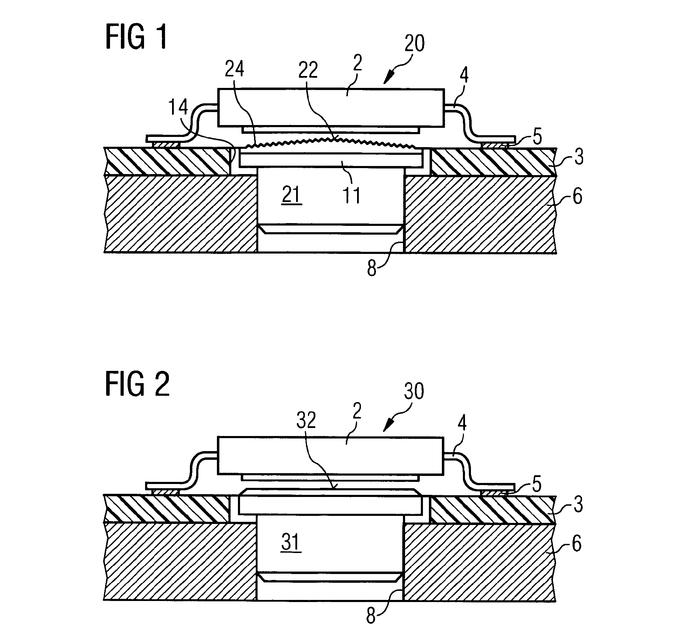

Ein Steuergerät 20 (Figur 1) für ein Kraftfahrzeug besteht im wesentlichen aus einer mit einer Anzahl von elektrischen und/oder elektronischen Bauelementen 2 bestückten Leiterplatte 3. Das Bauelement kann zum Beispiel als oberflächenmontierbares Bauelement (SMD) ausgebildet sein. Ein solches Steuergerät 20 wird in vielzähligen Ausführungen eingesetzt, zum Beispiel zum Steuern von Antiblockiersystemen (ABS) oder als Motor-, Getriebe-, Brems-, Klima-Steuergeräte usw.

Da derartige Steuergeräte für sich bekannt sind, wird in der Zeichnung nur ein Teil des Steuergeräts 20 dargestellt, der zum Erläutern der Erfindung ausreicht. Bekannte weitere Einzelheiten, wie die Verbindungen zur Stromversorgung und zu dem im Einzelfall zu steuernden Gerät sind nicht dargestellt.

Das Bauelemente 2 weist Anschlussdrähte 4 auf, die durch zwei Lötstellen 5 mit Leiterbahnen elektrisch verbunden ist, die auf der Leiterplatte 3 in bekannter Weise verlaufen. Die Leiterplatte 3 ist auf einer metallischen Grund- oder Trägerplatte 6 angeordnet, die zum Beispiel aus Aluminium besteht. Wegen ihrer guten Wärmeleitfähigkeit und ihrer großen Masse ist die Grundplatte sehr gut als Wärmesenke zum Abführen von in dem Steuergerät erzeugter Verlustwärme geeignet.

In einer Bohrung 8 in der Grundplatte 6 steckt ein längliches Metallteil 21, das hier als Kupferniet ausgebildet ist. An seinem in der Zeichnung oben liegenden Ende weist der Niet einen Nietkopf 11 auf, dessen dem Bauelement 2 zugewandte Stirnfläche 22 mit dem Bauelement verlötet wird. In der Zeichnung ist das Steuergerät 20 in dem Zustand vor dem endgültigen Verlöten dargestellt. Der Nietkopf 11 ragt durch eine Bohrung 14 in der Leiterplatte 3 hindurch, deren Durchmesser etwas größer als der Durchmesser des Nietkopfs ist.

Die Stirnfläche 22 von Figur 1 weist eine gegenüber der Stirnfläche 32 eines bekannten Kupferbolzens 31 (siehe Figur 2) dadurch vergrößerte Oberfläche auf, dass sie nach außen gewölbt oder ballig und außerdem geriffelt, d. h. mit einer Riffelung 24 versehen, ausgebildet ist. Dadurch ist die mit dem Bauelement 2 zu verlötende Oberfläche größer, was zu einer Verbesserung des Wärmeflusses führt. Die in dem Bauelement verursachte Verlustwärme fließt über die Stirnfläche 22 und den Nietkopf 11 in das längliche Metallteil 21 und von diesem in die Grundplatte 6, mit dem das längliche Metallteil, und genauer der Umfang seiner Längsachse, in enger Berührung steht. Es erfolgt eine Wärmeableitung über einen peripheren Kontakt des Metallteils mit der Grundplatte 6. Das Metallteil weist im wesentlichen entlang seiner gesamten kreisförmigen Umfangslinie einen Berührungskontakt zu der Grundplatte auf.

Wegen der gewölbten Form der Stirnfläche 12 kann das Lot beim Löten leicht nach außen abfließen, wodurch einer Bildung von Luftblasen in dem Lot stark entgegengewirkt wird. Dadurch wird der Wärmeabfluss und damit die Kühlung des Bauelements weiter verbessert.

Durch die Riffelung 24 wird die von dem Lot zu benetzende Oberfläche und die Lotmenge größer und damit auch der Wärmefluss erhöht. Durch die Riffelung auf der balligen Stirnfläche erwärmt sich dieselbe sehr gleichmäßig. Es verringert sich hierdurch die Menge des abfließenden Lots. Ferner ist eine besonders gleichmäßige Verteilung des eingebrachten Lotes (Lötzinn) gewährleistet. Beide Kontaktpartner werden besonders gut mit dem Lot benetzt. Die Gefahr eines Einschlusses von Sauerstoff (Luftblasenbildung) und die hiermit verbundene Bildung von wärmeübergangshemmenden Oxidschichten wird stark verringert. Somit wird das Bauelement 2 besonders wirksam gekühlt.

Die weiteren Teile des Steuergerätes 30 (Figur 2) haben die gleichen Bezugszeichen wie das Steuergerät 20 von Figur 1. Sie sind gegenüber diesem insoweit unverändert.

## Patentansprüche

1. Steuergerät (20) mit einem elektrischen Bauelement (2), in dem Wärme erzeugt wird, die über ein längliches Metallteil (21) abgeführt wird, dessen eine Stirnfläche (22) mit dem Bauelement (2) verlötet ist, **dadurch gekennzeichnet, dass** die dem Bauelement (2) zugewandte Stirnfläche (22) mit einer Riffelung (24) versehen ist.

2. Steuergerät nach Anspruch 1, **dadurch gekennzeichnet, dass** ein peripherer Kontakt des Metallteils (21) mit einer mit dem länglichen Metallteil (21) in enger Berührung stehenden Grundplatte (6) besteht.

3. Steuergerät nach einem der vorhergehenden Ansprüche, **dadurch gekennzeichnet, dass** das Metallteil (21) als Niet ausgebildet ist.

4. Steuergerät nach dem vorhergehenden Anspruch, **dadurch gekennzeichnet, dass** das Niet aus Kupfer hergestellt ist.
